# EUROPEAN PATENT APPLICATION

(11) **EP 0 660 268 A2**
(43) Date of publication of application: **28.06.1995**
(21) Application number: 94105868.7
(22) Date of filing: 15.04.1994
(51) Int. Cl.: G06F 17/50

(54) **Electronic model generation process**

(30) Priority: 15.10.1993 US 137842
(71) Applicant: CADENCE DESIGN SYSTEMS, San Jose, California 95134 (US)
(72) Inventor: Fitzpatrick, Daniel, Santa Clara, CA. 95050 (US); Kundert, Kenneth S., Belmont, CA. 94002 (US)
(74) Representative: Liesegang, Roland, Dr.-Ing.

(57) **Abstract**

An electronic design system modifies a behavioral model by: extracting a structural representation of the behavioral model which is constructed from a set of basic branch types (value probe, flow probe, value source, or flow source), generating from the structural representation a set of constitutive equations in a form compatible with an underlying simulator, and determining whether to provide automatically in the behavioral model an interconnection equation for coupling to a pair of nodes.

## Description

### 1. Field of the Invention

The invention relates to electronic design automaton (EDA) systems, particularly to EDA systems for modeling protype designs.

### 2. Description of the Background Art

Various computer-aided tools are used for automating the process of system design. Typically, such EDA tools are provided as integrated software and hardware for defining and verifying prototype digital or analog designs.

In many EDA tool suites, design verification is accomplished using a simulation tool or "simulator," which is provided as a software program, but which may also include specialized hardware for accelerating simulation.

To run a simulation of a prototype design, the simulator program is provided by a user with a definition of the prototype design. Typically, the prototype definition is provided as a netlist file or a simulation model, which is specified according to a netlisting or modelling syntax or language.

In particular, the netlisting or modeling syntax or language defines prototype functionality by specifying structure and/or behavior. In this context, structure includes the constituents or components of the prototype system, and parametric and interconnectivity information about such components. Furthermore, behavior includes mathematical equations or behavioral relations, terminal lists, and parameter lists that describe a particular component type or "primitive."

During simulation, the simulator predicts behavior of the prototype system in response to applied stimuli, essentially by constructing and solving a set of equations. The simulation equations are derived from the prototype system definition provided to the simulator, and accordingly may be constitutive or interconnective.

In particular, the simulator solves the constitutive and interconnection equations to determine how various signals, such as flow (e.g., current) or value (e.g., voltage) appear at certain nodes or terminals of components or interconnections according to the prototype definition.

Existing EDA tools facilitate prototype system definition by inferring some interconnection equations, generally by using a modified nodal analysis. Such known tools, however, still require users to define certain interconnection equations. For example, users of existing tools are required to define interconnection equations when a particular component is described with a constitutive relation that gives value as a function of flow. Similarly, interconnection equations are required when describing components with constitutive relation that gives value as a function of value, or that gives flow as a function of flow. It would be desirable, therefore, to provide a system development tool which is automated sufficiently, such that user definition of behavioral and structural parameters, particularly interconnection equations, is significantly reduced.

### SUMMARY OF THE INVENTION

The invention resides in an electronic design automation (EDA) system that accepts as input a netlist or model file, which defines a prototype analog design. The design includes component descriptions in the form of constitutive equations that relate the flows (e.g., current) and the values (e.g., voltage) between pairs of nodes. Depending on the constitutive relations, value probes, flow probes, value sources, or flow sources are used to access the signals on the nodes. The invention automatically creates the interconnection equations, for any possible configuration (e.g., val as function of val, val as function of flow, flow as function of val, or flow as function of flow), freeing the user from the complexity of specifying the interconnection equations.

### BRIEF DESCRIPTION OF THE DRAWINGS

FIG. 1 is a generalized flow chart of an improved electronic design automation (EDA) process, including model generation or equation formulation according to the present invention. Additionally, FIG. 2 is a more detailed flow chart illustrating the inventive process.

FIG. 3 is a simplified block diagram showing flow source 76 and value probe 74 coupled to node: 70, 72.

FIG. 4 is a simplified block diagram showing EDA system 80 enabling the present invention.

### DESCRIPTION OF THE PREFERRED EMBODIMENT

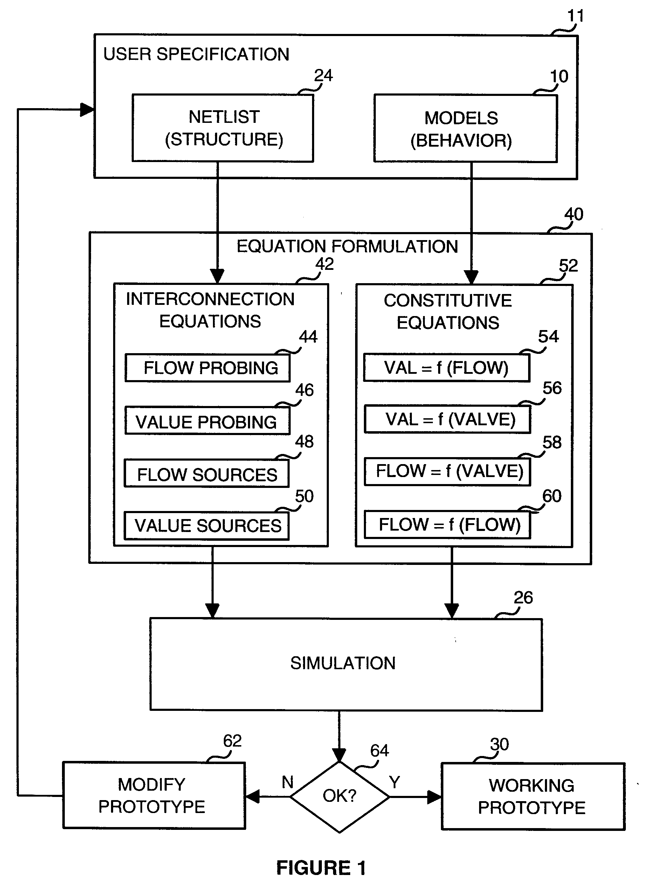

FIG. 1 is a flow chart of a computer-aided process for operating an electronic design automation system. Initially, user specification 11 of a prototype design is provided conventionally as an electronic file describing system or circuit structure (netlist) 24 and/or behavior (model) 10. Then, simulation equation formulation 40 is performed automatically largely through software programs and flies using conventional computing equipment to modify model 10 according to the present invention described herein.

In particular, upon receiving model 10, a structural representation of model 10 is extracted such that the structural representation is constructed from a set of basic branch types (e.g., value probe, flow probe, value source, or flow source). Based on the structural representation, a set of constitutive equations 52 (e.g., val=f(flow) 54, val=f(value) 56, flow=f(value) 58, flow=f(flow) 60) is generated in a form compatible with an underlying simulator 26. Additionally, it is determined whether to provide in model 10 an interconnection equation 42 (e.g., flow probing 44, value probing 46, flow sources 48, or value sources 20) for coupling to a pair of nodes in model 10. After equation formulation 40, conventional simulation 26 is performed on the formulated equations to determine 64 whether the prototype design is acceptable 30 or whether modification 62 is appropriate.

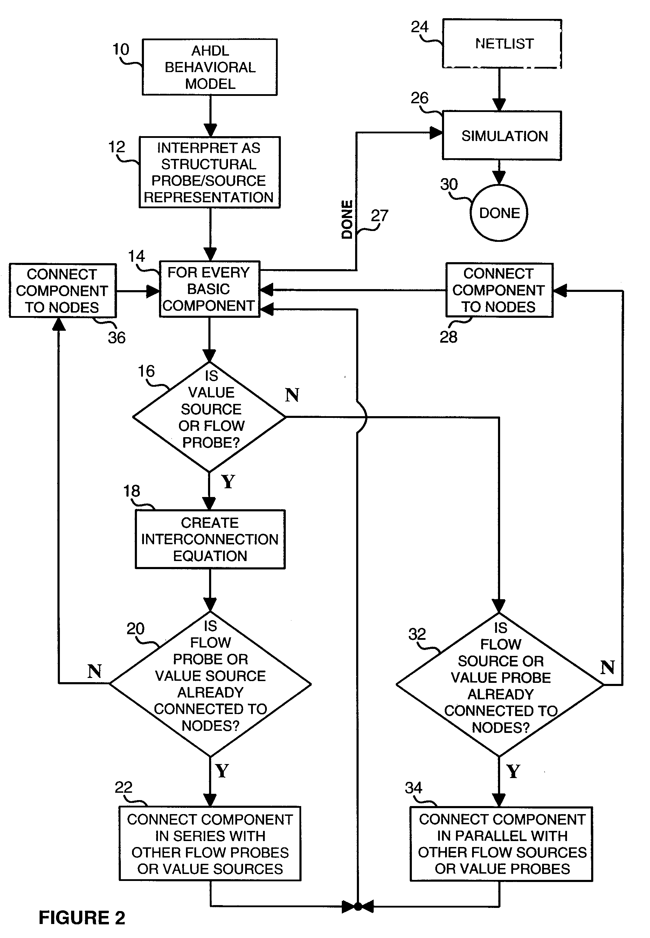

In FIG. 2, a flow chart illustrates additional detail in the process of equation formulation 40, which occurs upon receiving behavioral model 10, provided preferably according to an analog hardware description language (AHDL). Initially, model 10, which defines conventional constitutive elements and/or interconnective relationships, is identified or interpreted as pre-defined structural representations. In this way, a structural representation of model 10 is generated or constructed from a set of basic component or branch types, including a value probe, a flow probe, a value source, and a flow source. From such structural representation, a set of constitutive equations 52 (54-60) is generated or constructed, preferably in a form compatible with an underlying simulator. Moreover, an part of interpreting model 10 for structural representation, it is determined whether to provide automatically in model 10 an interconnect equation 42 for coupling to a pair of nodes included therein.

After model 10 interpretation 12 in performed in equation formulation 40, the generated structural representation is analyzed for every basic component or branch type 14, i.e., until analysis is done 27, at which point netlist 24 and the modified model 10 is simulated 26 and verified 30.

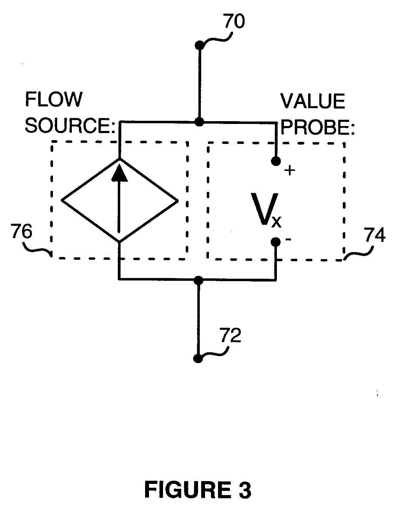

During basic component analysis 14, it is determined 16 for each identified basic component whether ouch basic component represents a value source (e.g., a voltage source) or a flow probe (e.g., a current probe). If it is determined that the identified basic component represents a value source or a flow probe, then an interconnection equation 42 is generated 18, preferably corresponding particularly to the basic component or branch type (e.g., flow probing 44, value probing 46, flow sources 48, value sources 50). Then, after interconnection equation 42 is generated, it is determined 20 whether an other flow probe or value source is coupled to a pair of nodes in the structural representation. If it is determined that the other flow probe or value source is not coupled thereto, then model 10 is modified 36 to couple the interconnection equation to the pair of nodes, Alternately, if it is determined that the other flow probe or value source is coupled thereto, then model 10 is modified 22 to couple serially the interconnection equation to the other flow probe or value source. Also, if it ii determined that the identified basic component does not represent a value source or a flow probe, then it is determined 32 whether an other flow source 76 or value probe 74 is coupled to the pair of nodes 70, 72 of the structural representation, as shown schematically in FIG. 3. If it is determined that the other flow source 76 or value probe 74 ii not coupled to pair of nodes 70, 72, then model 10 is modified 20 to couple the interconnection equation to nodes 70, 72. Alternately, if it is determined that the other flow source 76 or value probe 74 is coupled to nodes 70, 72, then model 10 is modified 34 to couple in parallel the interconnection equation to the other flow source 76 or value probe 74,

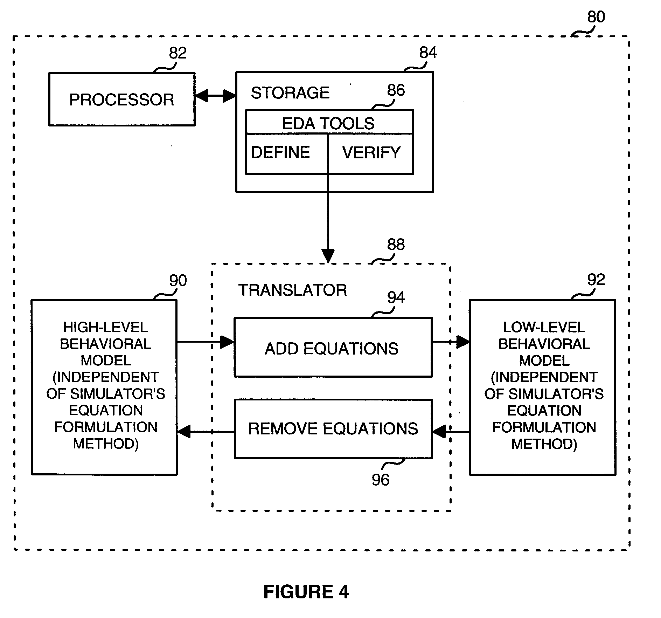

In FIG. 4, a block diagram is shown of electronic design automation (EDA) system 80 for implementing the present invention. System 80 includes conventional processor 02 and storage 84, which runs conventional EDA tools 86 for prototype system definition (e.g., netlisting/modeling) and verification (e.g., simulation). As detailed above, the present invention generally resides in providing in conjunction with EDA tools 86 a behavioral-model software translator or modifier 88, for converting a high-level behavioral model 90, which in independent of the underlying simulator's equation formulation method, to a low-level behavioral model 92, which is dependent on the underlying simulator's equation formulation method, essentially by adding certain interconnection equations 84 into the model. In an alternative embodiment, low-level behavioral model 92 may be converted to high-level behavioral model, essentially by identifying and removing such added interconnection equations.

## Claims

1. In an automated design system, a method for modifying a simulation model, the method comprising the steps of:
receiving a simulation model,
generating a structural representation of the simulation model according to a pre-defined branch type, and
generating from the structural representation a constitutive equation according to pre-defined simulation format.

2. The method of Claim 1 further comprising the step of:
identifying each branch type in the structural representation.

3. The method of Claim 2 further comprising the step of:
for each identified branch type, determining whether such identified branch type represents a value source or a flow probe.

4. The method of Claim 3 wherein:
an interconnection equation is generated, after determining that the identified branch type represents a value source or a flow probe.

5. The method of Claim 4 further comprising the step of:
determining, after generating the interconnection equation, whether an other flow probe or value source is coupled to a pair of nodes in the structural representation.

6. The method of Claim 5 further comprising the stop of:
modifying the simulation model to couple the interconnection equation to the pair of nodes, after determining that the other flow probe or value source is not coupled thereto.

7. The method of Claim 5 further comprising the atop of:
modifying the simulation model to couple serially the interconnection equation to the other flow probe or value source, after determining that the other flow probe or value source is coupled to the pair of nodes.

8. The method of Claim 3 further comprising the step of:
determining, after determining that the identified branch type does not represent a value source or a flow probe, whether an other flow source or value probe is coupled to a pair of nodes of the structural representation.

9. The method of Claim 8 further comprising the step of:
modifying the simulation model to couple the interconnection equation to the pair of nodes, after determining that the other flow source or value probe is not coupled thereto.

10. The method of Claim 8 further comprising the step of:
modifying the simulation model to couple in parallel the interconnection equation to the other flow source or value probe, after determining that the other flow source or value probe is coupled to the pair of nodes.
